(19) **Europäisches Patentamt**
**European Patent Office**
**Office européen des brevets**

(11) **EP 4 274 403 A1**

(12) **EUROPEAN PATENT APPLICATION**
published in accordance with Art. 153(4) EPC

(43) Date of publication:
**08.11.2023 Bulletin 2023/45**

(51) International Patent Classification (IPC):
**H10K 59/00** (2023.01)   **H10K 50/80** (2023.01)

(21) Application number: **22868733.1**

(86) International application number:
**PCT/CN2022/096404**

(22) Date of filing: **31.05.2022**

(87) International publication number:
**WO 2023/040356 (23.03.2023 Gazette 2023/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.09.2021 PCT/CN2021/118279**
**24.03.2022 PCT/CN2022/082809**

(71) Applicants:
• **BOE Technology Group Co., Ltd.**
**Beijing 100015 (CN)**
• **Chengdu BOE Optoelectronics Technology Co., Ltd.**
**Chengdu, Sichuan 611731 (CN)**

(72) Inventors:
• **WANG, Qiwei**
**Beijing 100176 (CN)**
• **HUANG, Weiyun**
**Beijing 100176 (CN)**
• **YANG, Ni**
**Beijing 100176 (CN)**
• **XU, Yuanjie**
**Beijing 100176 (CN)**
• **LU, Yanwei**
**Beijing 100176 (CN)**
• **DU, Lili**
**Beijing 100176 (CN)**

(74) Representative: **Klunker IP**
**Patentanwälte PartG mbB**
**Destouchesstraße 68**
**80796 München (DE)**

(54) **DISPLAY SUBSTRATE AND DISPLAY APPARATUS**

(57)     A display substrate and a display apparatus, the display substrate comprising a base substrate (BS), a plurality of pixel driving circuits (DR1/DR2), a first planarization layer (PLN1), a plurality of light-emitting devices (EL1/EL2), a first power supply signal line (VDD) and a data signal line (DT). The base substrate (BS) comprises a first display region (10) and a second display region (20). The first planarization layer (PLN1) comprises a device connection via (V1/V2) electrically connecting at least one of the plurality of pixel driving circuits (DR1/DR2) to at least one of the plurality of light-emitting devices (EL1/EL2), a power supply via (V3) electrically connecting at least one of the plurality of pixel driving circuits (DR1/DR2) to the first power supply signal line (VDD), and a data via (V4) electrically connecting at least one of the plurality of pixel driving circuits (DR1/DR2) to the data signal line DT. The device connection via (V1/V2), the power supply via (V3) and the data via (V4) are arranged along a first direction. The display substrate has good reliability.

Fig. 6

**Description**

CROSS-REFERENCE TO RELATED APPLICATIONS

For all the purposes, the present application claims the priorities to PCT International application No. PCT/CN2021/118279 filed on September 14, 2021 and PCT International application No. PCT/CN2022/082809 filed on March 24, 2022, and the entire disclosures of which are incorporated herein by reference as part of the present application.

TECHNICAL FIELD

Embodiments of the present disclosure relate to a display substrate and a display device.

BACKGROUND

Organic light-emitting diode (OLED) display and quantum-dot light-emitting diode (QLED) display are active light-emitting display devices, and have the advantages of self-luminescence, wide viewing angle, high contrast, low power consumption, extremely high response speed, small thickness and weight, high flexibility, low cost and the like. With the continuous development of display technology, display devices, in which OLED or QLED serves as a light-emitting element and signal is controlled by a thin film transistor (TFT), have become the mainstream products in the display field.

SUMMARY

At least one embodiment of the present disclosure provides a display substrate, which comprises: a base substrate, a plurality of pixel driving circuits, a first planarization layer, a plurality of light-emitting elements, a first power supply signal wire, and a data signal wire. The base substrate comprises a first display region and a second display region, wherein the first display region at least partially surrounds the second display region, and a light transmittance of the second display region is greater than a light transmittance of the first display region; the plurality of pixel driving circuits are provided on the base substrate and in the first display region; the first planarization layer is provided on a side of the plurality of pixel driving circuits facing away from the base substrate; the plurality of light-emitting elements are provided on a side of the first planarization layer facing away from the base substrate; the first power supply signal wire is provided on the side of the first planarization layer facing away from the base substrate and in the first display region; and the data signal wire is provided on the side of the first planarization layer facing away from the base substrate and in the first display region; the first planarization layer comprises an element connection via hole electrically connecting at least one of the plurality of pixel driving circuits with at least one of the plurality of light-emitting elements, a power supply via hole electrically connecting at least one of the plurality of pixel driving circuits with the first power supply signal wire, and a data via hole electrically connecting at least one of the plurality of pixel driving circuits with the data signal wire; the element connection via hole, the power supply via hole and the data via hole are arranged along a first direction.

For example, at least one embodiment of the present disclosure further comprises: a first initialization signal wire, configured to provide a first initialization signal to at least one of the plurality of pixel driving circuits; wherein a shortest distance between the element connection via hole and the first initialization signal wire, a shortest distance between the power supply via hole and the first initialization signal wire, and a shortest distance between the data via hole and the first initialization signal wire are substantially equal to each other.

For example, in at least one embodiment of the present disclosure, the plurality of pixel driving circuits comprise a first pixel driving circuit and a second pixel driving circuit, and the plurality of light-emitting elements comprise a first light-emitting element provided in the first display region and a second light-emitting element provided in the second display region; the element connection via hole comprises a first via hole and a second via hole, the first light-emitting element is electrically connected with the first pixel driving circuit through the first via hole, the second light-emitting element is electrically connected with the second pixel driving circuit through a first connection wire provided in the first display region and the second display region, and in the first display region, the first connection wire is electrically connected with the second pixel driving circuit through the second via hole.

For example, in at least one embodiment of the present disclosure, the plurality of pixel driving circuits comprise a plurality of pixel circuit groups extending in the first direction and arranged in a second direction, and at least one of the plurality of pixel circuit groups comprises a plurality of first pixel driving circuits and a plurality of second pixel driving circuits; a plurality of first via holes, a plurality of second via holes, a plurality of power supply via holes and a plurality of data via holes adopted by the plurality of first pixel driving circuits and the plurality of second pixel driving circuits are arranged along the first direction, and the first direction and the second direction intersect with each other.

For example, in at least one embodiment of the present disclosure, the plurality of first via holes, the plurality of second via holes, the plurality of power supply via holes and the plurality of data via holes adopted by the plurality of first pixel driving circuits and the plurality of second pixel driving circuits in the at least one of the plurality of pixel circuit groups are provided to have shortest distances substantially equal to each other from the first initialization signal wire.

For example, in at least one embodiment of the present disclosure, the plurality of first via holes, the plurality of second via holes, the plurality of power supply via holes and the plurality of data via holes adopted by the plurality of first pixel driving circuits and the plurality of second pixel driving circuits in the at least one of the plurality of pixel circuit groups are provided in a same straight line, and the same straight line extends along the first direction.

For example, in at least one embodiment of the present disclosure, in a direction parallel to the base substrate, the first connection wire is provided on at least one side of the same straight line.

For example, in at least one embodiment of the present disclosure, an extension direction of the first connection wire from the first display region to the second display region is parallel to the first direction.

For example, in at least one embodiment of the present disclosure, the first pixel driving circuit and the second pixel driving circuit respectively comprise a first transistor serving as a reset transistor, a second transistor serving as a compensation transistor and a third transistor serving as a driving transistor; a gate electrode of the first transistor is connected with a reset signal wire, a first electrode of the first transistor is connected with the first initialization signal wire, a second electrode of the first transistor is respectively connected with a first electrode of the second transistor and a gate electrode of the third transistor; a gate electrode of the second transistor is connected with a scanning signal wire, and a second electrode of the second transistor is connected with a second electrode of the third transistor; the gate electrode of the first transistor, the gate electrode of the second transistor, the gate electrode of the third transistor, the scanning signal wire and the reset signal wire are provided in a first conductive layer provided on the base substrate; the first initialization signal wire is provided in a second conductive layer, and the second conductive layer is provided on a side of the first conductive layer facing away from the base substrate.

For example, in at least one embodiment of the present disclosure, the first pixel driving circuit and the second pixel driving circuit further respectively comprise a storage capacitor, a fourth transistor serving as a data writing transistor and a fifth transistor serving as a light emission control transistor; a gate electrode of the fourth transistor is connected with the scanning signal wire, a first electrode of the fourth transistor is connected with the data signal wire, a second electrode of the fourth transistor is connected with a first electrode of the third transistor, a gate electrode of the fifth transistor is connected with a light emission control wire, a first electrode of the fifth transistor is connected with a second electrode plate of the storage capacitor, and a second electrode of the fifth transistor is connected with the first electrode of the third transistor; the light emission control wire is provided in the first conductive layer.

For example, in at least one embodiment of the present disclosure, the first pixel driving circuit and the second pixel driving circuit further respectively comprise a sixth transistor serving as a light emission control transistor and a seventh transistor serving as a reset transistor; a gate electrode of the sixth transistor is connected with the light emission control wire, a first electrode of the sixth transistor is connected with the second electrode of the third transistor, the first light-emitting element or the second light-emitting element is connected with a second electrode of the sixth transistor, a gate electrode of the seventh transistor is connected with the reset signal wire, a first electrode of the seventh transistor is connected with a second initialization signal wire, and a second electrode of the seventh transistor is connected with the second electrode of the sixth transistor; the second initialization signal wire is provided in the second conductive layer.

For example, in at least one embodiment of the present disclosure, in the first direction parallel to the base substrate, the second initialization signal wire, the reset signal wire, the first initialization signal wire and the scanning signal wire for a same first pixel driving circuit or a same second pixel driving circuit are sequentially arranged.

For example, in at least one embodiment of the present disclosure, the second transistor comprises an active layer and two gate electrodes, the active layer is provided in a semiconductor material layer provided between the first conductive layer and the base substrate; the active layer comprises a first portion, and an orthographic projection of the first portion on the base substrate does not overlap with orthographic projections of the two gate electrodes on the base substrate; the second conductive layer comprises a shielding pattern, and the orthographic projection of the first portion on the base substrate overlaps with an orthographic projection of the shielding pattern on the base substrate.

For example, in at least one embodiment of the present disclosure, the shielding pattern is integrally connected with the first initialization signal wire.

For example, in at least one embodiment of the present disclosure, the semiconductor material layer comprises a semiconductor pattern for connecting the active layer of the second transistor with an active layer of the first transistor; an orthographic projection of the semiconductor pattern on the base substrate overlaps with the orthographic projection of the shielding pattern on the base substrate.

For example, in at least one embodiment of the present disclosure, the first electrode and the second electrode of the first transistor, the first electrode and the second electrode of the second transistor, and the first electrode and the second electrode of the third transistor are provided in a third conductive layer, and the third conductive layer is provided on a side of the second conductive layer facing away from the base substrate.

For example, in at least one embodiment of the present disclosure, the first power supply signal wire is provided in a fourth conductive layer, and the fourth conductive layer is provided on a side of the third conductive layer facing away from the base substrate.

For example, in at least one embodiment of the present disclosure, the data signal wire is provided in the fourth conductive layer.

For example, in at least one embodiment of the present disclosure, the third conductive layer further comprises a connection portion provided between the second electrode of the first transistor and the gate electrode of the third transistor; the first power supply signal wire further comprises a protrusion; an orthographic projection of the connection portion on the base substrate overlaps with an orthographic projection of the protrusion on the base substrate.

For example, in at least one embodiment of the present disclosure, the orthographic projection of the connection portion on the base substrate is within the orthographic projection of the protrusion on the base substrate.

For example, in at least one embodiment of the present disclosure, an interval between patterns of the third conductive layer of the first pixel driving circuit and the second pixel driving circuit provided in two adjacent rows is from 7.0 microns to 10.0 microns.

For example, in at least one embodiment of the present disclosure, among the plurality of first pixel driving circuits and the plurality of second pixel driving circuits of at least one pixel circuit groups, two first pixel driving circuits are provided between every two adjacent second pixel driving circuits.

At least one embodiment of the present disclosure further comprises a display device provided by embodiments of the present disclosure.

BRIEF DESCRIPTION OF DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.

Fig. 1 is a schematic plan view of a display substrate provided by at least one embodiment of the present disclosure;

Fig. 2 is a schematic cross-sectional view of the display substrate in Fig. 1 taken along line B-B;

Fig. 3 is a schematic cross-sectional view of the display substrate in Fig. 1 taken along line A-A;

Fig. 4 is a partial plan view of a first display region and a second display region in the display substrate provided by at least one embodiment of the present disclosure;

Fig. 5 is a schematic plan view of some functional layers of the display substrate provided by at least one embodiment of the present disclosure;

Fig. 6 is another schematic plan view of some functional layers of the display substrate provided by at least one embodiment of the present disclosure;

Fig. 7 is a circuit diagram of a first pixel driving circuit of the display substrate provided by at least one embodiment of the present disclosure;

Fig. 8 is a circuit diagram of a second pixel driving circuit of the display substrate provided by at least one embodiment of the present disclosure;

Fig. 9 to Fig. 15 are schematic plan views of respective functional layers of the display substrate provided by at least one embodiment of the present disclosure and schematic plan views of overlapping the functional layers of the display substrate provided by at least one embodiment of the present disclosure in sequence; and

Figs. 16A to Fig. 16D are another schematic plan views of each of some functional layers of the display substrate provided by at least one embodiment of the present disclosure and another schematic plan views of overlapping some functional layers of the display substrate provided by at least one embodiment of the present disclosure in sequence.

DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise defined, the technical terms or scientific terms in the disclosure should be of general meaning as understood by those ordinarily skilled in the art. In the disclosure, expressions such as "first", "second" and the like do not denote any order, quantity, or importance, but rather are used for distinguishing different components. Expressions such as "comprise" or "comprise" and the like denote that elements or objects appearing before the words of "comprise" or "comprise" cover the elements or the objects enumerated after the words of "comprise" or "comprise" or equivalents thereof, not exclusive of other elements or objects. Expressions such as "connect" or "interconnect" and the like are not limited to physical or mechanical connections, but may comprise electrical connections, whether direct or indirect. Expressions such as "up", "down", "left", "right" and the like are only used for expressing relative positional relationship, the relative positional relationship may be correspondingly changed in the case that the absolute position of a described object is changed.

With the development of display technology, display products such as full screen, screen with narrow bezel and the like have gradually become the development trend of display products because of their large screen-to-body ratio and ultra-narrow bezel. For smart terminals and other products, hardware such as front camera, fingerprint sensor, light sensor and the like is usually required to be provided. In order to increase the screen-to-body ratio, products such as full screen or screen with narrow bezel usually adopt full display with camera (FDC) technology or under-display fingerprint technology, and the sensors such as camera are placed in the under-display camera (UDC) region of the display substrate, the under-display camera region not only has a certain light transmittance, but also has a display function, thus realizing the full display with camera (FDC).

In order to improve the light transmittance of the under-display camera region, each of the display sub-pixels provided in the under-display camera region usually only includes a light-emitting element, and a pixel driving circuit for driving the light-emitting element is provided in other display regions to avoid that the light transmittance of the under-display camera region is reduced in the case that the pixel driving circuit is provided in the under-display camera region. In the above solutions, a relatively long wire is needed to connect the light-emitting element to the pixel driving circuit provided in other display regions; the relatively long wire has a large resistance, which results in a voltage drop phenomenon; and the relatively long wire may form a parasitic capacitance with other circuit patterns on the display substrate, which adversely affects the electrical signal transmission of the display substrate. In addition, because of a high refresh rate of the display substrate, the charging time of each of the display sub-pixels provided in the under-display camera region is not enough, which affects the brightness of the light-emitting element. In addition, for a purpose of achieving the electrical connections between circuits, many via holes are provided in the display substrate, and the circuits or wires provided above these via holes are easy to have depressions at the positions of the via holes, which leads to defects such as circuit breaking, thus reducing the reliability of the display substrate.

At least one embodiment of the present disclosure provides a display substrate; the display substrate comprises a base substrate, a plurality of pixel driving circuits, a first planarization layer, a plurality of light-emitting elements, a first power supply signal wire and a data signal wire; the base substrate comprises a first display region and a second display region, the first display region at least partially surrounds the second display region, and a light transmittance of the second display region is greater than a light transmittance of the first display region; the plurality of pixel driving circuits are provided on the base substrate and in the first display region; the first planarization layer is provided on a side of the plurality of pixel driving circuits facing away from the base substrate; the plurality of light-emitting elements are provided on a side of the first planarization layer facing away from the base substrate; the first power supply signal wire is provided on the side of the first planarization layer facing away from the base substrate and in the first display region; the data signal wire is provided on the side of the first planarization layer facing away from the base substrate and in the first display region; the first planarization layer comprises an element connection via hole electrically connecting at least one of the plurality of pixel driving circuits with at least one of the plurality of light-emitting elements, a power supply via hole electrically connecting at least one of the plurality of pixel driving circuits with the first power supply signal wire and a data via hole electrically connecting at least one of the plurality of pixel driving circuits with the data signal wire, and the element connection via hole, the power supply via hole and the data via hole are arranged in a first direction.

In the display substrate provided by the embodiments of the present disclosure, various wires and circuit patterns are provided on the first planarization layer; by arranging the plurality of via holes in the first planarization layer along the first direction, the arrangement space of the plurality of via holes are more compact and regular so as to facilitate these wires and circuit patterns provided on the first planarization layer to avoid these via holes, so that these wires or circuit patterns are prevented from depressing at the positions of the via holes to cause defects such as short circuit, and thus the stability of these wires and circuit patterns are improved, and the reliability of the display substrate is improved.

Next, the display substrate provided by the embodiments of the present disclosure will be described in detail by referring to specific embodiments.

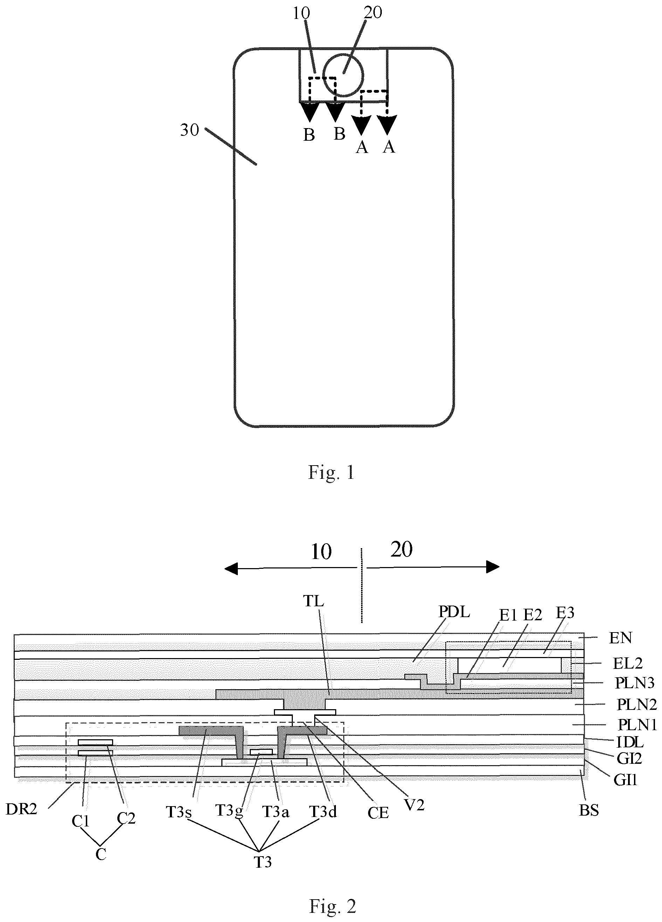

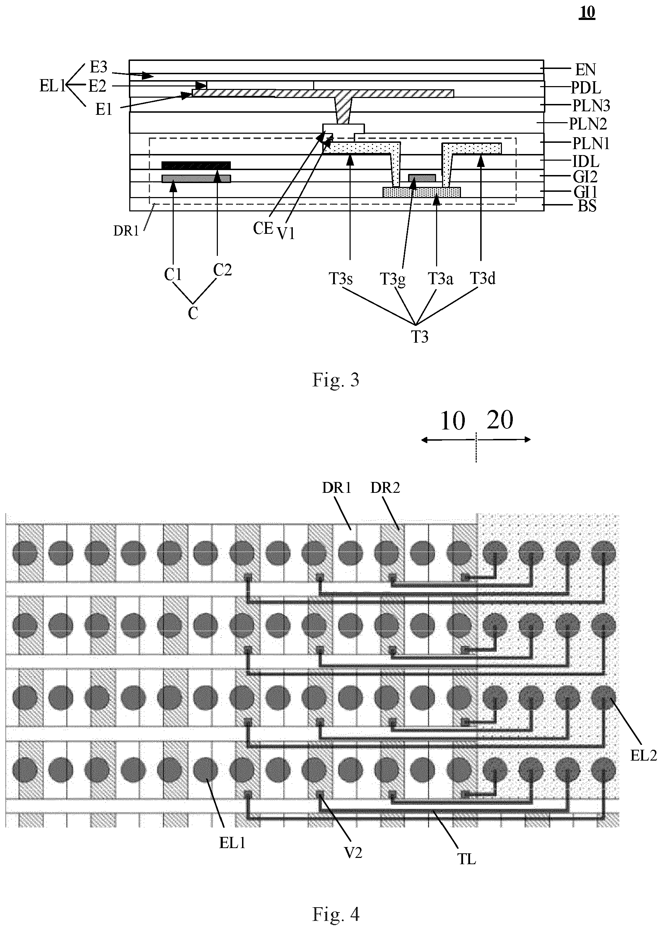

At least one embodiment of the present disclosure provides a display substrate, Fig. 1 shows a schematic plan view of the display substrate, Fig. 2 shows a schematic cross-sectional view of the display substrate in Fig. 1 taken along line B-B, Fig. 3 shows a schematic cross-sectional view of the display substrate in Fig. 1 taken along line A-A, and Fig. 4 shows a partial schematic plan view of a first display region and a second display region of the display substrate in Fig. 1. As shown in Figs. 1 to 4, the display substrate comprises a base substrate BS, a plurality of pixel driving circuits DR1/DR2, a first planarization layer PLN1, a plurality of light-emitting elements EM1/EM2, a first power supply signal wire VDD, a data signal wire DT and the like. The base substrate BS comprises a first display region 10 and a second display region 20, and the first display region 10 at least partially surrounds the second display region 20. In Fig. 1, it is shown that the first display region 10 completely surrounds the second display region 20. In other embodiments, the first display region 10 for example partially surrounds the second display region 20.

The light transmittance of the second display region 20 is greater than the light transmittance of the first display region 10. For example, the second display region 20 is a light-transmitting display region of the display substrate, which transmits some light signals.

For example, the plurality of pixel driving circuits DR1/DR2 are provided on the base substrate BS and in the first display region 10, the first planarization layer PLN1 is provided on a side of the plurality of pixel driving circuits DR1/DR2 facing away from the base substrate BS, the plurality of light-emitting elements EM1/EM2 are provided on the side of the first planarization layer PLN1 facing away from the base substrate BS; the first power supply signal wire VDD is provided on the side of the first planarization layer PLN1 facing away from the base substrate BS and in the first display region 10; and the data signal wire DT is provided on the side of the first planarization layer PLN1 facing away from the base substrate 110 and in the first display region 10.

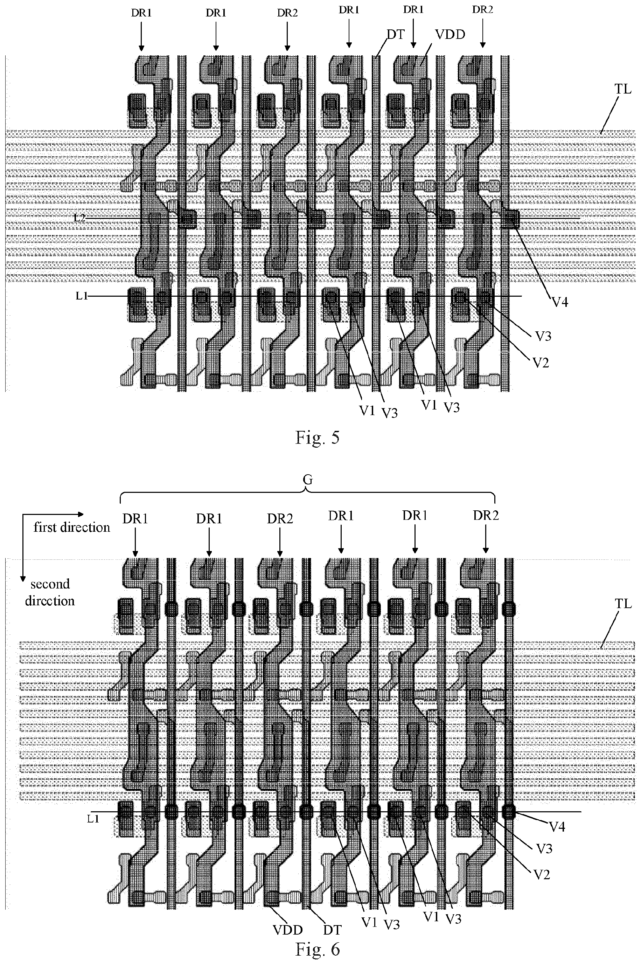

Referring to Fig. 6, the first planarization layer PLN1 comprises an element connection via hole V1/V2 electrically connecting at least one (e.g., each) of the plurality of pixel driving circuits DR1/DR2 with at least one (e.g., each) of the plurality of light-emitting elements EM1/EM2, a power supply via hole V3 electrically connecting at least one (e.g., each) of the plurality of pixel driving circuits with the first power supply signal wire VDD, and a data via hole V4 electrically connecting at least one (e.g., each) of the plurality of pixel driving circuits with the data signal wire DT; the element connection via hole V1/V2, the power supply via hole V3 and the data via hole V4 are arranged along a first direction (e.g., a horizontal direction in Fig. 6).

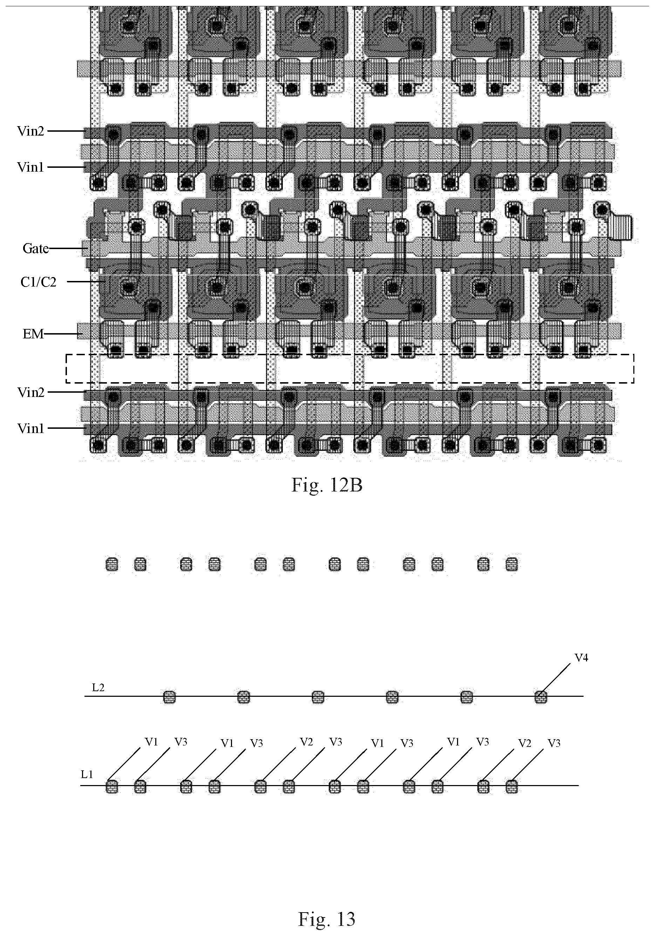

For example, referring to Fig. 12B, the display substrate further comprises a first initialization signal wire Vin1, and the first initialization signal wire Vin1 is configured to provide a first initialization signal to at least one of the plurality of pixel driving circuits DR1/DR2; a shortest distance between the element connection via hole V1/V2 and the first initialization signal wire Vin1, a shortest distance between the power supply via hole V3 and the first initialization signal wire Vin1, and a shortest distance the data via hole V4 and the first initialization signal wire Vin1 are substantially equal to each other, that is, the element connection via hole V1/V2, the power supply via hole V3 and the data via hole V4 are respectively arranged at positions having substantial same distances to the first initialization signal wire Vin1. For example, the first initialization signal wire Vin1 extends in the first direction.

Therefore, the arrangement space of a plurality of first via holes V1, a plurality of second via holes V2, a plurality of power supply via holes V3 and a plurality of data via holes V4 is more compact and regular so as to facilitate a plurality of wires (for example, a first connection wire TL) and circuit patterns provided on the first planarization layer PLN1 to avoid these via holes, the stability of these wires and circuit patterns is improved, and the reliability of the display substrate is improved.

For example, in the embodiment of Fig. 1, the second display region 20 is circular; in other embodiments, the second display region 20 for example is in a rectangular, triangular, elliptical shape and the like. For example, in the case that the second display region 20 is circular, a diameter of the circle is about 3mm to 5 mm; in the case that the second display region 20 is rectangular, a long side length and a short side length of the rectangle is respectively about 3mm to 5mm. The embodiments of the present disclosure do not limit the specific shape and size of the second display region 20.

For example, the plurality of pixel driving circuits comprise a plurality of first pixel driving circuits DR1 and a plurality of second pixel driving circuits DR2, the plurality of light-emitting elements comprise a first light-emitting element EM1 provided in the first display region 10 and a second light-emitting element EM2 provided in the second display region 20, the element connection via hole comprise a first via hole V1 and a second via hole V2, the first light-emitting element EM1 is electrically connected with the first pixel driving circuit DR1 through the first via hole V1, the second light-emitting element EM2 is electrically connected with the second pixel driving circuit DR2 through the first connection wire TL provided in the first display region 10 and the second display region 20, and in the first display region 10, the first connection wire TL is electrically connected with the second pixel driving circuit DR2 through the second via hole V2.

For example, as shown in Figs. 2 and 3, the first display region 10 is configured to display images, and comprises the plurality of first pixel driving circuits DR1, the plurality of second pixel driving circuits DR2, the first planarization layer PLN1, and the plurality of first light-emitting elements EL1; the plurality of first pixel driving circuits DR1 and the plurality of second pixel driving circuits DR2 are arranged in rows and columns, as shown in Fig. 4, a direction of each row is for example the horizontal direction in the figure, and a direction of each column is for example the vertical direction in the figure. The first planarization layer PLN1 is provided on the side of the plurality of first pixel driving circuits DR1 and the plurality of second pixel driving circuits DR2 facing away from the base substrate BS. The plurality of first light-emitting elements EL1 are provided on the side of the first planarization layer PLN1 facing away from the base substrate BS.

For example, each of the first pixel driving circuit DR1 and the second pixel driving circuit DR2 comprises a structure composed of transistor and storage capacitor, such as a 2T1C structure (that is, comprising two transistors and one storage capacitor C), a 3T1C structure, a 7T1C structure, an 8T2C structure and the like. The embodiments of the present disclosure do not limit the specific forms of the first pixel driving circuit DR1 and the second pixel driving circuit DR2. For example, Figs. 2 and 3 show a driving transistor, which for example is a third transistor T3 in the 7T1C structure described in detail later.

For example, as shown in Figs. 2 and 3, the third transistor T3 in the first pixel driving circuit DR1 and the second pixel driving circuit DR2 comprises an active layer T3a, a gate electrode T3g, a first electrode T3s and a second electrode T3d. The storage capacitor C comprises a first electrode plate C1 and a second electrode plate C2. For example, the gate electrode T3g and the first electrode plate C1 are provided in a first conductive layer Gate1 (which is described in detail later), the second electrode plate C2 is provided in a second conductive layer Gate2 (which is described in detail later) provided on a side of the first conductive layer Gate1 facing away from the base substrate, and the first electrode T3s and the second electrode T3d are provided in a third conductive layer SD1 (which is described in detail later) provided on a side of the second conductive layer Gate2 facing away from the base substrate.

For example, a first gate insulating layer GI1 is provided between the active layer T3a and the gate electrode T3g, a second gate insulating layer GI2 is provided between the first electrode plate C1 and the second electrode plate C2, and an interlayer insulating layer IDL is provided between the second electrode plate C2 and the first electrode T3s (as well as the second electrode T3d). For example, the active layer T3a comprises a channel region, a first region and a second region provided on two sides of the channel region. A semiconductor material of the first region and the second region are treated to be conductive, the first electrode T3s and the second electrode T3d are respectively connected with the first region and the second region of the active layer T3a through via holes in the first gate insulating layers GI1 and the second gate insulating layer GI2.

For example, the first light-emitting element EL1 and the second light-emitting element EL2 are electrically connected with the first pixel driving circuit DR1 and the second pixel driving circuit DR2 respectively through a connection electrode CE, and the connection electrode CE is provided in a fourth conductive layer SD2 (which is described in detail later) provided on a side of the third conductive layer facing away from the base substrate.

For example, each of the first light-emitting element EL1 and the second light-emitting element EL2 is an OLED, and comprises a first electrode E1 (e.g., an anode), an organic light-emitting layer E2 and a second electrode E3 (e.g., a cathode) which are stacked, referring to Figs. 2 and 3. Alternatively, each of the first light-emitting element EL1 and the second light-emitting element EL2 is a QLED, and comprises a first electrode E1 (for example, an anode), a quantum dot layer E2 and a second electrode E3 (for example, a cathode) which are stacked. For example, in some embodiments, the second electrodes E3 of the first light-emitting element EL1 and the second light-emitting element EL2 are formed into a surface electrode continuously provided in the display substrate.

For example, an encapsulation layer EN are provided on the first light-emitting element EL1 and the second light-emitting element EL2. For example, the encapsulation layer EN comprises a first encapsulation layer, a second encapsulation layer and a third encapsulation layer (not shown in the figure) which are stacked. The first encapsulation layer and the third encapsulation layer for example are made of an inorganic material, such as silicon oxide, silicon nitride, silicon oxynitride and the like, and the second encapsulation layer for example is made of an organic material, such as polyimide, resin and the like. The second encapsulation layer is provided between the first encapsulation layer and the third encapsulation layer, so as to ensure that external water vapor do not enter into the first light-emitting element EL1 and the second light-emitting element EL2.

For example, Fig. 6 shows a schematic plan view of some functional layers of the display substrate in Fig. 1. As shown in Figs. 2, 3 and 6, the first planarization layer PLN1 comprises a plurality of first via holes V1, a plurality of second via holes V2, a plurality of power supply via holes V3 and a plurality of data via holes V4, and the plurality of first light-emitting elements EL1 are respectively electrically connected with the plurality of first pixel driving circuits DR1 (for example, the first electrode or the second electrode of the third transistor) through the plurality of first via holes V1 (for example, first electrode connection electrodes CE provided in the first via holes V1). Thus, the plurality of first light-emitting elements EL1 are driven in an "in-situ" driving mode, as shown in Fig. 3.

As shown in Fig. 2, Fig. 4 and Fig. 6, the second display region 20 is configured to display images and transmit light, and comprises the plurality of second light-emitting elements EL2; the plurality of second light-emitting elements EL2 are respectively electrically connected with the plurality of second pixel driving circuits DR2 (for example, the first electrode or the second electrode of the third transistor) through a plurality of first connection wires TL extending in the first display region 10 and the second display region 20; and in the first display region 10, the plurality of first connection wires TL are respectively electrically connected with the plurality of second pixel driving circuits DR2 through the plurality of second via holes V2 (for example, the first electrode connection electrodes CE provided in the second via holes V2). Therefore, the plurality of second light-emitting elements EL2 are driven in a "remote" driving mode, as shown in Fig. 2.

It should be noted that in the embodiments of the present disclosure, one structure being electrically connected with another structure through the via hole, means that the one structure is directly electrically connected with the other structure through the via hole, or the one structure is indirectly electrically connected with the other structure through a connecting structure provided in the via hole, as long as the electrical connection between the one structure and the other structure is realized through the via hole.

For example, in some embodiments, as shown in Fig. 1, the display substrate further comprises a third display region 30, the third display region 30 is a main display region of the display substrate and comprises the plurality of first pixel driving circuits DR1 and the plurality of second pixel driving circuits DR2, and further comprises a plurality of third light-emitting elements. In the third display region 30, the plurality of first pixel driving circuits DR1 are respectively electrically connected with the plurality of third light-emitting elements to drive the plurality of third light-emitting elements; however, the plurality of second pixel driving circuits DR2 in the third display region 30 differs from those in the second display region 20 in that, the plurality of second pixel driving circuits DR2 in the third display region 30 are not electrically connected with any light-emitting element.

For example, as shown in Fig. 6, the first power supply signal wire VDD is electrically connected with the plurality of first pixel driving circuits DR1 and the plurality of second pixel driving circuits DR2 through the plurality of power supply via holes V3, so as to provide a power supply signal, such as a high-level signal, for the plurality of first pixel driving circuits DR1 and the plurality of second pixel driving circuits DR2.

For example, as shown in Fig. 6, the plurality of pixel driving circuits comprise a plurality of pixel circuit groups G (e.g., pixel driving circuit rows, one group/row is shown in the figure as an example) extending in a first direction (e.g., the horizontal direction in the figure) and arranged in a second direction (e.g., the vertical direction in the figure), and at least one group of the plurality of pixel circuit groups G comprises the plurality of first pixel driving circuits DR1 and the plurality of second pixel driving circuits DR2. The plurality of first via holes V1, the plurality of second via holes V2, the plurality of power supply via holes V3 and the plurality of data via holes V4 adopted by the plurality of first pixel driving circuits DR1 and the plurality of second pixel driving circuits DR2 are arranged along the first direction, and the first direction and the second direction intersect with each other.

For example, the plurality of first via holes V1, the plurality of second via holes V2, the plurality of power supply via holes V3 and the plurality of data via holes V4 adopted by the plurality of first pixel driving circuits DR1 and the plurality of second pixel driving circuits DR2 in at least one pixel circuit group G are provided to have shortest distances substantially equal to each other from the first initialization signal wire Vin1.

For example, the plurality of first via holes V1, the plurality of second via holes V2, the plurality of power supply via holes V3 and the plurality of data via holes V4 adopted by the plurality of first pixel driving circuits DR1 and the plurality of second pixel driving circuits DR2 in at least one pixel circuit group G are provided in a same straight line L1, and the same straight line L1 extends along the first direction.

Therefore, the arrangement space of the plurality of first via holes V1, the plurality of second via holes V2, the plurality of power supply via holes V3 and the plurality of data via holes V4 is more compact and regular, so as to facilitate the plurality of wires (for example, the first connection wire TL) and circuit patterns provided on the first planarization layer PLN1 to avoid these via holes, the stability of these wires and circuit patterns is improved, and the reliability of the display substrate is improved.

For example, in the embodiments of the present disclosure, the plurality of via holes being provided in the same straight line, means that the same straight line sequentially passes through the plurality of via holes, for example, the same straight line sequentially passes through the plurality of via holes at any position of each via hole and is not limited to pass through the centers of the plurality of via holes. Of course, in some embodiments, the centers of the plurality of first via holes V1, the plurality of second via holes V2, the plurality of power supply via holes V3 and the plurality of data via holes V4 are provided in the same straight line L1, so as to regularly arrange the plurality of first via holes V1, the plurality of second via holes V2, the plurality of power supply via holes V3 and the plurality of data via holes V4 to the greatest extent.

For example, in some embodiments, in a direction parallel to the base substrate BS, a plurality of first connection wires TL are provided on at least one side of the same straight line (that is, the first straight line L1). For example, the plurality of first connection wires TL are provided between two straight lines L1 in each of which the plurality of second via holes V2, the plurality of power supply via holes V3 and the plurality of data via holes V4 adopted by two adjacent rows of the first pixel driving circuit DR1 and the second pixel driving circuit DR2 are respectively provided.

For example, in some embodiments, the extension direction of the plurality of first connection wires TL from the first display region 10 to the second display region 20 (that is, the horizontal direction in the figure) is parallel to the above-described same straight line (that is, the first straight line L1), for example the plurality of first connection wires TL extend in the first direction, so that in the direction perpendicular to the base substrate, the plurality of first connection wires TL do not overlap with the plurality of first via holes V1, the plurality of second via holes V2, the plurality of power supply via holes V3 and the plurality of data via holes V4 provided in the first straight line L1, thereby avoiding defects such as short circuit, circuit breaking and the like caused by the case that the plurality of first connection wires TL being arranged above the via holes.

For example, in some display substrates, as shown in Fig. 5, the data signal wire DT is electrically connected with the plurality of first pixel driving circuits DR1 and the plurality of second pixel driving circuits DR2 through the plurality of data via holes V4. Orthographic projections of the plurality of data via holes V4 on the base substrate BS are provided between orthographic projections of two adjacent first connection wires TL on the base substrate BS. In Fig. 5, the plurality of first via holes V1, the plurality of second via holes V2 and the plurality of power supply via holes V3 adopted by the first pixel driving circuits DR1 and the second pixel driving circuits DR2 are provided in the first straight line L1, and the plurality of data via holes V4 adopted by the first pixel driving circuits DR1 and the second pixel driving circuits DR2 are provided in a second straight line L2 different from the first straight line L1.

Compared with the embodiment of Fig. 5, in the embodiment of Fig. 6, the plurality of via holes provided in the first planarization layer PLN1 and adopted by the first pixel driving circuits DR1 and the second pixel driving circuits DR2 in the same group (for example, in the same row) are provided in the same straight line, thereby further saving the arrangement space of the via holes and allowing the plurality of first connection wires TL to completely avoid the plurality of via holes in the first planarization layer PLN1, so that the reliability of the plurality of first connection wires TL is improved.

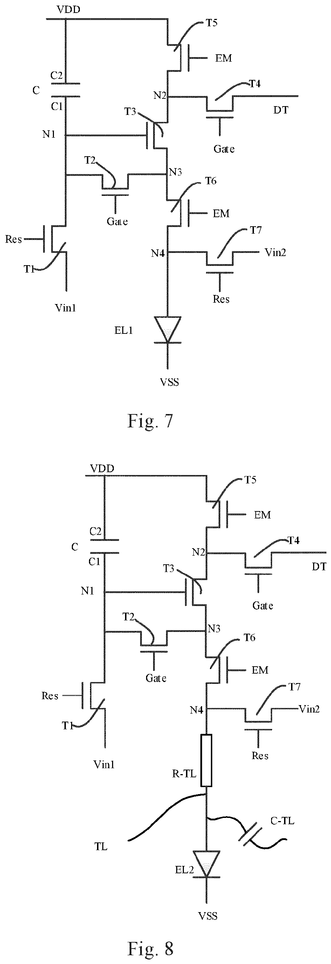

For example, Fig. 7 shows a circuit diagram of the first pixel driving circuit DR1 and Fig. 8 shows a circuit diagram of the second pixel driving circuit DR2. As shown in Figs. 7 and 8, the first pixel driving circuit DR1 and the second pixel driving circuit DR2 respectively comprise a first transistor T1 serving as a reset transistor, a second transistor T2 serving as a compensation transistor and a third transistor T3 serving as a driving transistor. A gate electrode of the first transistor T1 is connected with a reset signal wire Res, a first electrode of the first transistor T1 is connected with the first initialization signal wire Vin1, a second electrode of the first transistor T1 is connected with a first electrode of the second transistor T2, a gate electrode of the third transistor T3 and the first electrode plate C1 of the storage capacitor C, respectively. A gate electrode of the second transistor T2 is connected with a scanning signal wire Gate, and a second electrode of the second transistor T2 is connected with a second electrode of the third transistor T2.

For example, the second electrode of the first transistor T1, the gate electrode of the third transistor T3 and the first electrode plate C1 of the storage capacitor C converges at a node N1.

For example, the gate electrode of the first transistor T1, the gate electrode of the second transistor T2, the gate electrode of the third transistor T3, the first electrode plate C1 of the storage capacitor C, the scanning signal wire Gate and the reset signal wire Res are provided in the first conductive layer on the base substrate BS, which is also called as a Gate1 layer in the following. The first initialization signal wire Vin1 is provided in the second conductive layer, which is also called as a Gate2 layer in the following, and the second conductive layer is provided on the side of the first conductive layer facing away from the base substrate BS.

For example, as shown in Figs. 7 and 8, the first pixel driving circuit DR1 and the second pixel driving circuit DR2 respectively further comprise the storage capacitor C, a fourth transistor T4 serving as a data writing transistor and a fifth transistor T5 serving as a light emission control transistor; a gate electrode of the fourth transistor T4 is connected with the scanning signal wire Gate, a first electrode of the fourth transistor T4 is connected with the data signal wire DT, a second electrode of the fourth transistor T4 is connected with the first electrode of the third transistor T3, a gate electrode of the fifth transistor T5 is connected with a light emission control wire EM, a first electrode of the fifth transistor T5 is connected with the second electrode plate C2 of the storage capacitor C, the first electrode of the fifth transistor T5 and the second electrode plate C2 of the storage capacitor C are connected with the first power supply signal wire VDD, and a second electrode of the fifth transistor T5 is connected with the first electrode of the third transistor T3.

For example, the second electrode of the fourth transistor T4, the first electrode of the third transistor T3 and the second electrode of the fifth transistor T5 converges at a node N2.

For example, the gate electrode of the fourth transistor T4, the gate electrode of the fifth transistor T5, and the light emission control wire EN are provided in the first conductive layer.

For example, as shown in Figs. 7 and 8, the first pixel driving circuit DR1 and the second pixel driving circuit DR2 respectively further comprise a sixth transistor T6 serving as a light emission control transistor and a seventh transistor T7 serving as a reset transistor; a gate electrode of the sixth transistor T6 is connected with the light emission control wire EM, a first electrode of the sixth transistor T6 is connected with the second electrode of the third transistor T3, the first electrode of the first light-emitting element EL1 or the second light-emitting element EL2 is connected with a second electrode of the sixth transistor T6; a gate electrode of the seventh transistor T7 is connected with the reset signal wire Res, a first electrode of the seventh transistor T7 is connected with a second initialization signal wire Vin2, and a second electrode of the seventh transistor T7 is connected with a second electrode of the sixth transistor T6.

For example, the first electrode of the sixth transistor T6 and the second electrode of the third transistor T3 converges at a node N3. The second electrode of the sixth transistor T6 and the second electrode of the seventh transistor T7 converges at a node N4.

For example, the second electrodes of the first light-emitting element EL1 and the second light-emitting element EL2 are connected with a second power supply wire VSS. For example, the signal transmitted by the second power supply wire VSS is a low-level signal, and the signal transmitted by the first power supply signal wire VDD is a high-level signal.

Therefore, in the embodiments shown in Figs. 7 and 8, each of the first pixel driving circuit DR1 and the second pixel driving circuit DR2 has a 7T1C structure (i.e., comprising seven transistors and one storage capacitor).

For example, the gate electrode of the sixth transistor T6 and the gate electrode of the seventh transistor T7 are provided in the first conductive layer, and the second electrode plate C2 of the storage capacitor C and the second initialization signal wire Vin2 are provided in the second conductive layer.

For example, the first electrode and the second electrode of the first transistor T1, the first electrode and the second electrode of the second transistor T2, the first electrode and the second electrode of the third transistor T3, the first electrode and the second electrode of the fourth transistor T4, the first electrode and the second electrode of the fifth transistor T5, the first electrode and the second electrode of the sixth transistor T6, and the first electrode and the second electrode of the seventh transistor T7 are provided in the third conductive layer (also called as a SD1 layer), and the third conductive layer is provided on a side of the second conductive layer facing away from the base substrate BS.

In an embodiments of the present disclosure, for example, the first electrode is the drain electrode of the transistor, the second electrode is the source electrode of the transistor; or, for example, the first electrode is the source electrode of the transistor, the second electrode is the drain electrode of the transistor. The functions of "source electrode" and "drain electrode" are sometimes interchanged when adopted transistors have opposite polarities or a current direction changes during circuit operation.

For example, the first power supply signal wire VDD is provided in the fourth conductive layer (also called as a SD2 layer), and the fourth conductive layer is provided on a side of the third conductive layer facing away from the base substrate BS. For example, the data signal wire DT is also provided in the fourth conductive layer.

For example, in the first pixel driving circuit DR1 and the second pixel driving circuit DR2 shown in Figs. 2 and 3, the thin film transistor connected with the first light-emitting element EL1 or the second light-emitting element EL2 is the above-mentioned third transistor T3.

For example, the above-mentioned circuit structures of the first pixel driving circuit DR1 and the second pixel driving circuit DR2 are substantially the same; and the difference between the circuit structures of the first pixel driving circuit DR1 and the second pixel driving circuit DR2 is that: as shown in Fig. 8, the second light-emitting element EL2 is connected with the second pixel driving circuit DR2 through a long first connection wire TL extending in the first display region 10 and the second display region 20, which is equivalent to connecting a resistor R-TL in series and connecting a capacitor C-TL in parallel between the node N4 (where the sixth thin film transistor T6 and the seventh thin film transistor converges) and the second light-emitting element EL2.

For example, in the embodiments of the present disclosure, as shown in Figs. 4 to 6, among the plurality of first pixel driving circuits DR1 and the plurality of second pixel driving circuits DR2 provided in the same row, two first pixel driving circuits DR1 are provided between every two adjacent second pixel driving circuits DR2. That is, in the first display region 10, every two first pixel driving circuits DR1 and one second pixel driving circuit DR2 constitute a repeating unit, and a plurality of repeating units are periodically provided in the first display region 10.

For example, the plurality of second pixel driving circuits DR2 for connecting the plurality of second light-emitting elements EL2 are provided near the second display region 20, so that the length of the first connection wire TL is sufficiently reduced, thereby weakening or even eliminating the resistor R-TL and the capacitor C-TL provided between the node N4 and the second light-emitting element EL2, and solving the problems of relatively low brightness, insufficient charging time at high frequency, and the like of the second light-emitting element EL2 in the second display region 20. On the other hand, the total number of the first pixel driving circuits DR1 by which the first connection wiring TL passes is reduced, so that the defects such as breakage of the first connection wiring TL passing by the first pixel driving circuit DR1 is reduced.

For example, in some embodiments, the first transistor T1 to the seventh transistor T7 are thin film transistors, such as P-type thin film transistors or N-type thin film transistors. For example, the first pixel driving circuit adopts the same type of transistors, so as to simplify the manufacture process, reduce the manufacture process difficulty of the display panel and improve the free-defect ratio of products.

For example, in some embodiments, the first transistor T1 to the seventh transistor T7 adopt low-temperature polysilicon transistors, or adopt oxide transistors, or adopt low-temperature polysilicon transistors and metal oxide transistors. The low temperature polysilicon transistor adopts low temperature poly-silicon (LTPS) as the active layer thereof, and the metal oxide transistor adopts metal oxide semiconductor as the active layer thereof. The low-temperature polysilicon transistor has the advantages of high mobility, fast charging and the like, while the oxide transistor has the advantages of low leakage current and the like. By integrating the low-temperature polysilicon transistor and the metal oxide transistor on the same display substrate to form a low-temperature polycrystalline oxide (LTPO) display substrate, the advantages of the low-temperature polysilicon transistor and the oxide transistor are combined, so as to realize low-frequency driving, reduce power consumption and improve display quality.

For example, taking the first transistor T1 to the seventh transistor T7 being P-type thin film transistors as an example, the operation process of the first pixel driving circuit are as follows.

In the first stage A1 which is called as the reset stage, the signal of the reset signal wire Res is a turning-on signal, and the signals of the scanning signal wire Gate and the light-emitting signal wire EM are turning-off signals. The turning-on signal of the reset signal wire Res turns on the first transistor T1, and the signal of the first initialization signal wire Vin1 is supplied to the first node N1 through the first transistor T1 to initialize (reset) the storage capacitor C and eliminate the original charges stored in the storage capacitor. The turning-on signal of the reset signal wire Res turns on the seventh transistor T7, and the signal of the second initialization signal wire Vin2 is supplied to the first electrode of the first light-emitting element EL1 or the second light-emitting element EL2 through the seventh transistor T7, so that the first electrode of the first light-emitting element EL1 or the second light-emitting element EL2 is initialized (reset), and the pre-stored voltage in the first light-emitting element EL1 or the second light-emitting element EL2 is eliminated so as to complete initialization. The turning-off signals of the scanning signal wire Gate and the light-emitting signal wire EM turn off the second transistor T2, the fourth transistor T4, the fifth transistor T5 and the sixth transistor T6, and the first light-emitting element EL1 or the second light-emitting element EL2 does not emit light at this stage.

In the second stage A2 which is called as a data writing stage or a threshold compensation stage, the signal of the scanning signal wire Gate is the turning-on signal, the signals of the reset signal wire Res and the light-emitting signal wire EM are turning-off signals, and the data signal wire DT outputs a data voltage. At this stage, because the first electrode plate of the storage capacitor C is at a low level, the third transistor T3 is turned on. The turning-on signal of the scanning signal wire Gate turns on the second transistor T2 and the fourth transistor T4, and the data voltage output by the data signal wire DT is supplied to the first node N1 by passing through the second node N2, the turned-on third transistor T3, the third node N3 and the turned-on second transistor T2; the voltage difference between the data voltage output by the data signal wire DT and the threshold voltage of the third transistor T3 is charged into the storage capacitor C. The voltage of the first electrode plate (the first node N1) of the storage capacitor C is Vd-|Vth|, Vd is the data voltage output by the data signal wire DT, and Vth is the threshold voltage of the third transistor T3. The turning-off signal of the reset signal wire Res turns off the first transistor T1 and the seventh transistor T7, and the turning-off signal of the light-emitting signal wire EM turns off the fifth transistor T5 and the sixth transistor T6.

In the third stage A3 which is called as a light-emitting stage, the signal of the light-emitting signal wire EM is the turning-on signal, and the signals of the scanning signal wire Gate and the reset signal wire Res are the turning-off signals. The turning-on signal of the light-emitting signal wire EM turns on the fifth transistor T5 and the sixth transistor T6, and the power supply voltage output by the first power supply signal wire VDD provides a driving voltage to the first electrode of the first light-emitting element EL1 or the second light-emitting element EL2 through the turned-on fifth transistor T5, the third transistor T3 and the sixth transistor T6 to drive the first light-emitting element EL1 or the second light-emitting element EL2 to emit light.

In the driving process of the first pixel driving circuit DR1 or the second pixel driving circuit DR2, the driving current flowing through the third transistor T3 (driving transistor) is determined by the voltage difference between the gate electrode and the first electrode of the third transistor T3. Because the voltage of the first node N1 is Vd-|Vth|, the driving current of the third transistor T3 is:

$$I = K*(Vgs-Vth)2 = K*[(Vdd-Vd+|Vth|)-Vth]2 = K*[(Vdd-Vd]2$$

Where I is the driving current flowing through the third transistor T3, that is, the driving current is the current driving the first light-emitting element EL1 or the second light-emitting element EL2, K is a constant, Vgs is the voltage difference between the gate electrode and the first electrode of the third transistor T3, Vth is the threshold voltage of the third transistor T3, Vd is the data voltage output by the data signal wire D, and Vdd is the power voltage output by the first power supply signal wire VDD.

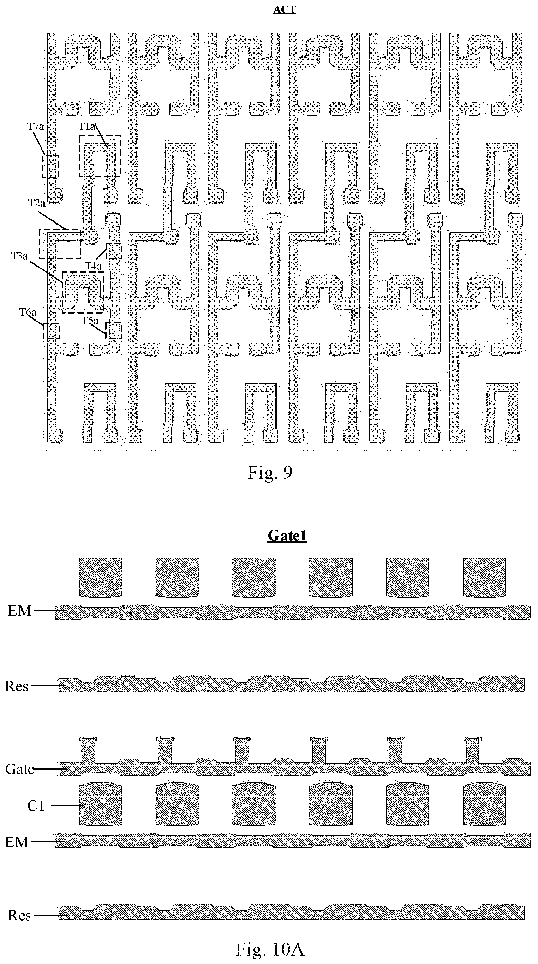

For example, Figs. 9 to15 show schematic plan views of respective functional layers of the display substrate in the embodiment shown in Fig. 5.

Fig. 9 shows a schematic plan view of the semiconductor layer ACT provided on the base substrate. As shown in Fig. 9, the semiconductor layer ACT comprises the active layer T1a of the first transistor 11, the active layer T2a of the second transistor T2, the active layer T3a of the third transistor T3, the active layer T4a of the fourth transistor T4, the active layer T5a of the fifth transistor t5, the active layer T6a of the sixth transistor T6 and the seventh active layer T7a of the seventh transistor T7.

For example, the active layers of these transistors are connected into an integral structure. For example, in each column of pixel driving circuits, the active layer T6a of the sixth transistor T6 of the pixel driving circuit of the M-th row and the active layer T7a of the seventh transistor T7 of the pixel driving circuit of the (M+1)-th row are connected with each other, that is, the active layers of adjacent pixel driving circuits among the pixel driving circuits in each column are connected into the integral structure.

For example, the active layer T1a of the first transistor T1 is of "n" shape, the active layer T2a of the second transistor T2 is of "L" shape, the active layer T3a of the third transistor T3 is of "Ω" shape, and the shapes of the active layer T4a of the fourth transistor T4, the active layer T5a of the fifth transistor T5, the active layer T6a of the sixth transistor T6 and the active layer T7a of the seventh transistor T7 each are of "I" shape.

For example, the active layer of each transistor comprises the channel region, and the first region and the second region provided on two sides of the channel region. The first region and the second region have electrical conductivity and are respectively used for electrical connection with the first electrode and the second electrode of each transistor.

For example, referring to Figs. 2 and 3, the first gate insulating layer GI1 is formed on the semiconductor layer ACT, which will not be described here.

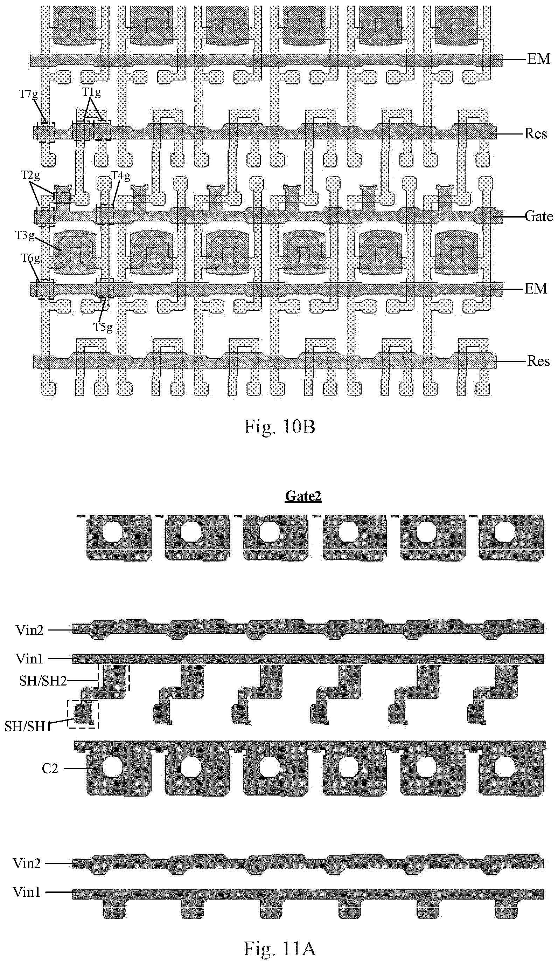

Fig. 10A shows a schematic plan view of the first conductive layer Gate1 provided on the semiconductor layer ACT, and Fig. 10B shows a schematic plan view of the first conductive layer Gate1 overlapping with the semiconductor layer ACT. As shown in Figs. 10A and 10B, the pattern of the first conductive layer Gate1 of each of the first pixel driving circuit and second pixel driving circuit at least comprises the reset signal wire Res, the scanning signal wire Gate, the emission control wire EM and the first electrode plate C1 of the storage capacitor C.

For example, the shape of the first electrode plate C1 of the storage capacitor C is rectangular, the corners of the rectangle for example are chamfered, and the orthographic projection of the first electrode plate C1 on the base substrate at least partially overlaps with the orthographic projection of the active layer of the third transistor T3 on the base substrate. For example, the first electrode plate C1 of the storage capacitor C further serves as the gate electrode of the third transistor T3.

For example, each of the shapes of the reset signal wire Res, the scanning signal wire Gate and the light emission control wire EM is of a straight line shape in which the main portion extends along the row direction of the pixel driving circuits.

As shown in Fig. 10B, the portion of the scanning signal wire Gate overlapping with the active layer of the second transistor T2 is used as the gate electrode T2g of the second transistor T2. For example, the scanning signal wire Gate is provided with a protrusion protruding towards the reset signal wire Res, and the orthographic projection of the protrusion on the base substrate at least partially overlaps with the orthographic projection of the active layer of the second transistor T2 on the base substrate, thereby forming the second transistor T2 with a double-gate structure.

For example, the portion of the scanning signal wire Gate overlapping with the active layer of the fourth transistor T4 is used as the gate electrode T4g of the fourth transistor T4, the portion of the reset signal wire Res overlapping with the active layer of the first transistor is use as the gate electrode T1g of the first transistor T1 of double-gate structure, the portion of the reset signal wire Res overlapping with the active layer of the seventh transistor T7 is used as the gate electrode T7g of the seventh transistor T7, the portion of the light emission control wire EM overlapping with the active layer of the fifth transistor T5 is used as the gate electrode T5g of the fifth transistor T5, and the portion of the light emission control wire EM overlapping with the active layer of the sixth transistor T6 is used as the gate electrode T6g of the sixth transistor T6.

For example, referring to Figs. 2 and 3, the second gate insulating layer GI2 is formed on the first conductive layer Gate1, which will not be described here.

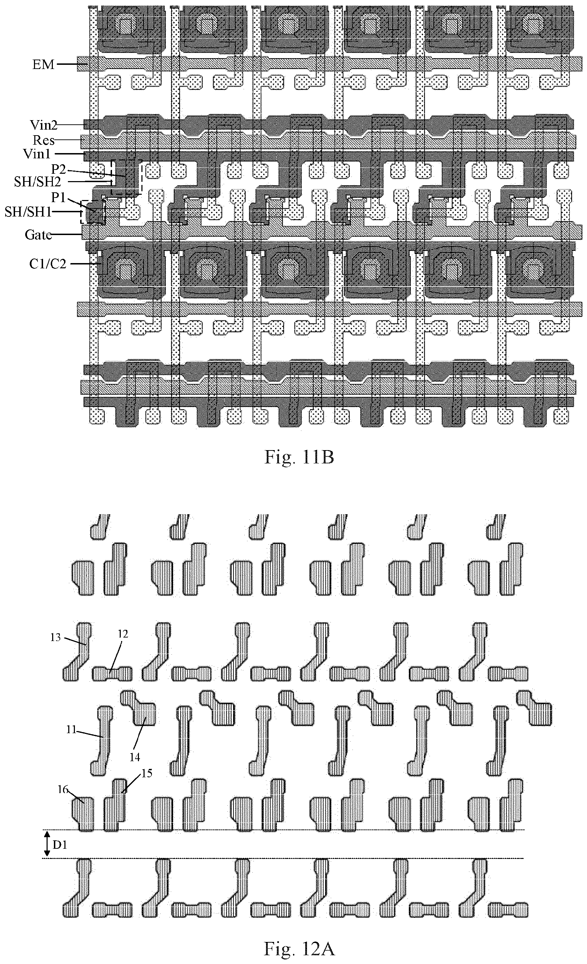

Fig. 11A shows a schematic plan view of the second conductive layer Gate2 provided on the first conductive layer Gate1, and Fig. 11B shows a schematic plan view of the second conductive layer Gate2 overlapping with the first conductive layer Gate1 and the semiconductor layer ACT. As shown in Figs. 11A and 11B, the pattern of the second conductive layer Gate2 of each of the first pixel driving circuit and the second pixel driving circuit at least comprises the first initialization signal wire Vin1, the second initialization signal wire Vin2, the second electrode plate C2 of the storage capacitor C, and a shielding pattern SH.

For example, as shown in Fig. 11B, the active layer of the second transistor T2 has a first portion P1 provided between two gate electrodes of the second transistor T2, and the orthographic projection of the first portion P1 on the base substrate does not overlap with the orthographic projections of the two gate electrodes on the base substrate, and the orthographic projection of the first portion P1 on the base substrate overlaps with the orthographic projection of the shielding pattern SH (for example, a first shielding portion SH1 of the shielding pattern SH) on the base substrate. Therefore, the shielding pattern SH shields the active layer of the second transistor T2 and stabilizes the voltage of the active layer of the second transistor T2.

For example, the shielding pattern SH is of a zigzag line shape, and the shielding pattern SH is integrally connected with the first initialization signal wire Vin1, so that the shielding pattern SH obtains a constant voltage signal from the first initialization signal wire Vin1 to fully achieve the function of voltage stabilization.

For example, as shown in Fig. 11B, the semiconductor layer ACT comprises a semiconductor pattern P2 connecting the active layer of the second transistor T2 and the active layer of the first transistor T1, and the orthographic projection of the semiconductor pattern P2 on the base substrate overlaps with the orthographic projection of the shielding pattern SH (for example, a second shielding portion SH2 of the shielding pattern SH) on the base substrate.

Therefore, the shielding pattern SH also prevents the influence of data voltage jumping on key nodes (such as N1 node), so as to avoid the influence of the data voltage jumping on the electrical potential of key nodes of the pixel driving circuit and achieve the effect of voltage stabilization.

For example, the second electrode plate C2 of the storage capacitor C is provided between the scanning signal wire Gate and the light emission control wire EM, and the second electrode plates C2 adjacent to each other in the row direction for example are electrically connected to each other, so as to ensure that the plurality of second electrode plates C2 in the same row have the same electrical potential, which facilitate to improve the uniformity of the display substrate and further improve the display effect of the display substrate.

For example, the profile of the second electrode plate C2 is rectangular, the corners of the rectangle for example are chamfered, and the orthographic projection of the second electrode plate C2 on the base substrate at least partially overlaps the orthographic projection of the first electrode plate C1 on the base substrate to form the storage capacitor C of the pixel driving circuit. The second electrode plate C2 for example is provided with an opening, and the opening for example is provided in the middle of the second electrode plate C2. The opening for example is in rectangular shape, so that the second electrode plate C2 forms an annular structure. For example, the opening is configured to accommodate a later-formed connection via hole, and the connection via hole is provided in the opening and exposes the first electrode plate C1, so that the later-formed second electrode of the first transistor T1 is connected with the first electrode plate C1 through the connection via hole.

For example, the shapes of the first initialization signal wire Vin1 and the second initialization signal wire Vin2 are of straight line shapes in which the main portion extends along the row direction.

For example, as shown in Fig. 11B, the second initialization signal wire Vin2, the reset signal wire Res, the first initialization signal wire Vin1 and the scanning signal wire Gate for the same first pixel driving circuit DR1 or second pixel driving circuit DR2 are arranged in sequence in the second direction parallel to the base substrate, that is, in the column direction in the figure. Therefore, the signal wires in the first conductive layer Gate1 and the signal wires in the second conductive layer Gate2 are alternately arranged to avoid signal crosstalk, short circuit and other defects caused by arranging too dense signal wires in the same conductive layer.

For example, referring to Figs. 2 and 3, an interlayer insulating layer IDL is formed on the second conductive layer Gate2, which will not be described here.

Fig. 12A shows a schematic plan view of the third conductive layer SD1 provided on the second conductive layer Gate2, and Fig. 12B shows a schematic plan view of the third conductive layer SD1 overlapping with the second conductive layer Gate2, the first conductive layer Gate1 and the semiconductor layer ACT. As shown in Figs. 12A and 12B, the pattern of the third conductive layer SD1 of each of the first pixel driving circuit and second pixel driving circuit at least comprises a first connection electrode 11, a second connection electrode 12, a third connection electrode 13, a fourth connection electrode 14, a fifth connection electrode 15 and a sixth connection electrode 16.

For example, the first connection electrode 11 is of a strip shape in which the main portion extends in the column direction, a first end of the first connection electrode 11 is connected with the first electrode C1 through a via hole, and a second end of the first connection electrode 11 is connected with the second region of the active layer of the first transistor T1 (or the first region of the active layer of the second transistor T1) through a via hole, so that the first electrode C1, the second electrode of the first transistor T1 and the first electrode of the second transistor T2 have the same electrical potential. For example, the first connection electrode 41 simultaneously serves as the second electrode of the first transistor T1 and the first electrode of the second transistor T2.

For example, the second connection electrode 12 is of a strip shape extending along the row direction, a first end of the second connection electrode 12 is connected with the first region of the active layer of the first transistor through a via hole, and a second end of the second connection electrode 12 is connected with the first initialization signal wire Vin1 through a via hole. For example, the second connection electrode 12 is used as the first electrode of the first transistor T1, so that the first initialization signal wire Vin1 writes the first initial signal into the first transistor T1.

For example, the third connection electrode 13 is of a zigzag line shape, a first end of the third connection electrode 13 is connected with the first region of the active layer of the seventh transistor through a via hole, and a second end of the third connection electrode 13 is connected with the second initialization signal wire Vint2 through a via hole. For example, the third connection electrode 13 is used as the first electrode of the seventh transistor T7, so that the second initialization signal wire Vint2 writes the second initial signal into the seventh transistor T7.

For example, the fourth connection electrode 14 is of a dumbbell shape, and the fourth connection electrode 14 is connected with the first region of the active layer of the fourth transistor through a via hole. For example, the fourth connection electrode 14 serves as the first electrode of the fourth transistor T4, and the fourth connection electrode 44 is configured to be connected with the data signal wire DT formed later.

For example, the fifth connection electrode 15 is approximately of "Z" shape, a first end of the fifth connection electrode 15 is connected with the first region of the active layer of the fifth transistor T5 through a via hole, and a second end of the fifth connection electrode 15 is connected with the second electrode plate C2 through a via hole, so that the second electrode plate C2 and the first region of the active layer of the fifth transistor T5 have the same electrical potential. For example, the fifth connection electrode 15 serves as the first electrode of the fifth transistor T5.

For example, the shape of the sixth connection electrode 16 is rectangular, and the sixth connection electrode 16 is connected with the second region of the active layer of the sixth transistor T6 (which is also the second region of the active layer of the seventh transistor T7) through a via hole, so that the second region of the active layer of the sixth transistor T6 and the second region of the active layer of the seventh transistor T7 have the same electrical potential. For example, the sixth connection electrode 16 serves as the second electrode of the sixth transistor T6 (or the second electrode of the seventh transistor T7).

For example, as shown in Fig. 12A, an interval D1 between the patterns of the third conductive layer SD1 of the first pixel driving circuit DR1 and the second pixel driving circuit DR2 provided in two adjacent rows is from 7.0 microns to 10.0 microns, for example, 8.0 microns, 8.5 microns, 9.0 microns or 9.5 microns. Therefore, the patterns of the third conductive layer SD1 of the first pixel driving circuit DR1 and the second pixel driving circuit DR2 in two adjacent rows have a large interval, which provides an arrangement space for other circuit patterns and wires of the display substrate.

For example, Fig. 13 shows a schematic plan view of the first planarization layer PLN1 provided on the third conductive layer SD1. As shown in Fig. 13, the first planarization layer PLN1 comprises the plurality of first via holes V1, the plurality of second via holes V2, the plurality of power supply via holes V3 and the plurality of data via holes V4. The plurality of first via holes V1 are configured to connect the first electrode connection electrodes CE adopted by the first light-emitting elements EL1 with the first pixel driving circuits DR1, the plurality of second via holes V2 are configured to connect the first electrode connection electrodes CE adopted by the second light-emitting elements EL2 with the second pixel driving circuits DR2, the plurality of power supply via holes V3 are configured to connect the first power supply signal wire VDD (which is formed later) with the first pixel driving circuits DR1 or the second pixel driving circuits DR2, and the plurality of data via holes V4 are configured to connect the data signal wire DT (which is formed later) with the first pixel driving circuits DR1 or the second pixel driving circuits DR2.

In the embodiment of Fig. 13, the plurality of first via holes V1, the plurality of second via holes V2 and the plurality of power supply via holes V3 are provided in the same straight line, that is, the first straight line L1, and the plurality of data via holes V4 are provided in another straight line, that is, the second straight line L2.

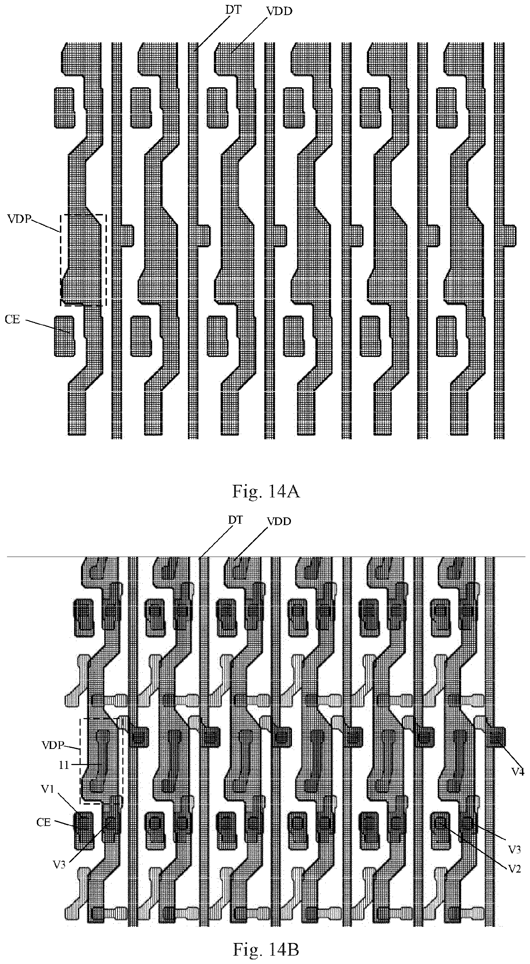

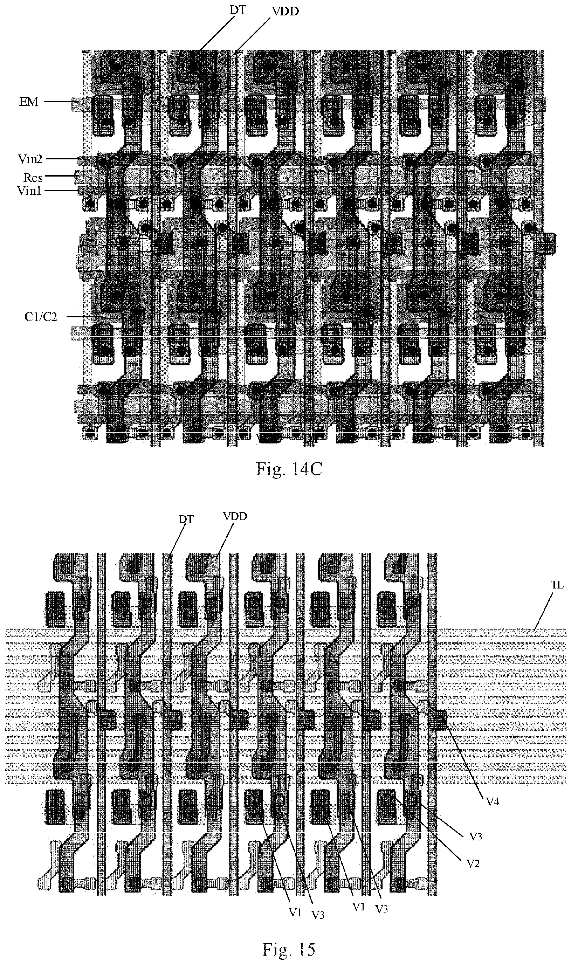

Fig. 14A shows a schematic plan view of the fourth conductive layer SD2 provided on the first planarization layer PLN1, and Fig. 14B shows a schematic plan view of the fourth conductive layer SD2 overlapping with the third conductive layer SD1; Fig. 14C shows a schematic plan view of the fourth conductive layer SD2 overlapping with the third conductive layer SD1, the second conductive layer Gate2, the first conductive layer Gate1 and the semiconductor layer ACT. As shown in Figs. 14A, 14B and 14C, the pattern of the fourth conductive layer SD2 of each of the first pixel driving circuit and the second pixel driving circuit at least comprises the first electrode connection electrode CE, the data signal wire DT and the first power supply signal wire VDD.

For example, the first electrode connection electrode CE is configured to connect the first electrode of the first light-emitting element EL1 with the first pixel driving circuit DR1 or to connect the first electrode of the second light-emitting element EL2 with the second pixel driving circuit DR2.

For example, the shape of the data signal wire DT is a straight line in which the main portion extends in the column direction, and the data signal wire TD is connected with the fourth connection electrode 14 through the data via hole V4. Because the fourth connection electrode 14 is connected with the first region of the active layer of the fourth transistor T4 through the via hole, the data signal wire DT writes the data signal into the first electrode of the fourth transistor T4.

For example, the first power supply signal wire VDD is of a zigzag shape in which the main portion extends in the column direction, and the first power supply signal wire VDD is connected with the fifth connection electrode 15 through the power supply via hole V3. Because the fifth connection electrode 15 is connected with the second electrode plate C2 and the first region of the active layer of the fifth transistor T5 through the via hole, the first power supply signal wire VDD writes the first power signal into the first electrode of the fifth transistor T5, and the second electrode plate C2 and the first electrode of the fifth transistor T5 have the same electrical potential.

For example, as shown in Fig. 14B, the third conductive layer SD1 comprises a connection portion (i.e., the above-mentioned first connection electrode 11) provided between the second electrode of the first transistor T1 and the gate electrode of the third transistor T3; the first power supply signal wire VDD comprises a protrusion VDP, and the orthographic projection of the connection portion (i.e., the above-mentioned first connection electrode 11) on the base substrate overlaps with the orthographic projection of the protrusion VDP on the base substrate. For example, the orthographic projection of the connection portion (i.e., the first connection electrode 11) on the base substrate is within the orthographic projection of the protrusion VDP on the base substrate. Therefore, the protrusion VDP shields the N1 node.

Therefore, in the embodiments of the present disclosure, the third conductive layer SD1 comprises only connection electrodes (the first connection electrode 11 to the sixth connection electrode 16) for signal transfer and electrical connection, so a larger interval D1 is reserved for other circuits or wirings, as shown in Fig. 12A. The fourth conductive layer SD2 comprises the first power supply signal wire VDD and the data signal wire DT. The first power supply signal wire VDD comprises the protrusion VDP to shield the N1 node, and the data signal wire DT is provided in the fourth conductive layer SD2 to reduce the voltage drop caused by signal transmission, shorten the charging time, and realize high refresh rate of display.

For example, referring to Figs. 2 and 3, the second planarization layer PLN2 is provided on the fourth conductive layer SD2, and the first connection wire TL is provided on the second planarization layer PLN2, as shown in Fig. 15, the third planarization layer PLN3 is provided on the first connection wire TL.

For example, in some embodiments, the first connection wire TL is provided in multiple functional layers. In this case, a part of the first connection wire TL is provided on the second planarization layer PLN2, the third planarization layer PLN3 is provided on the part of the first connection wire TL; another part of the first connection wire TL is provided on the third planarization layer PLN3, and the fourth planarization layer is provided on the another part of the first connection wire TL; still another part of the first connection wire TL is provided on the fourth planarization layer, and the fifth planarization layer PLN5 is provided on the still another part of the first connection wire TL.

For example, the first light-emitting element EL1 and the second light-emitting element EL2 are provided on the fifth planarization layer PLN5. The encapsulation layer EN is provided on the first light-emitting element EL1 and the second light-emitting element EL2.

For example, a transparent conductive material, for example a transparent metal oxide such as indium tin oxide (ITO), indium zinc oxide (IZO) and the like, is used as the material of the first connection wire TL to further improve the light transmittance of the second display region 20.

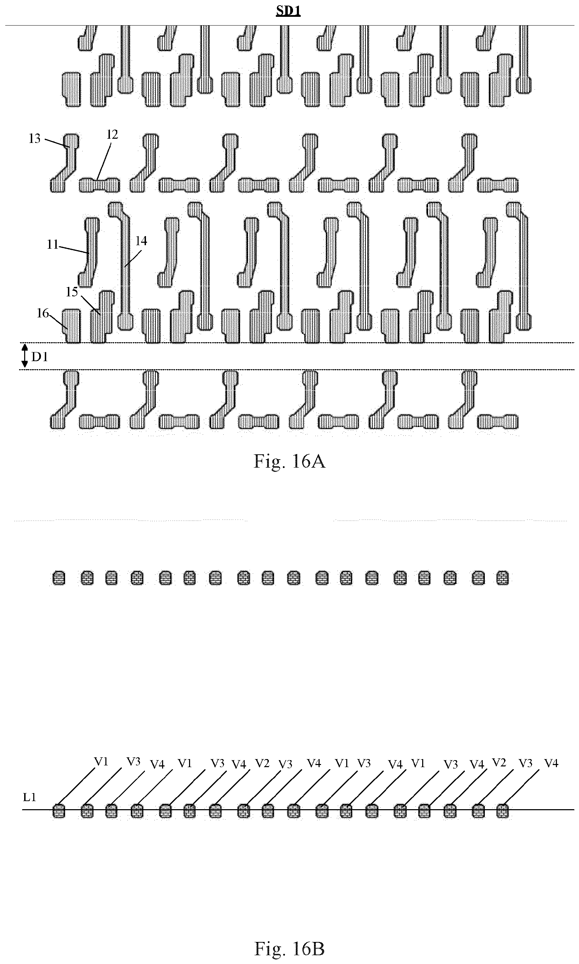

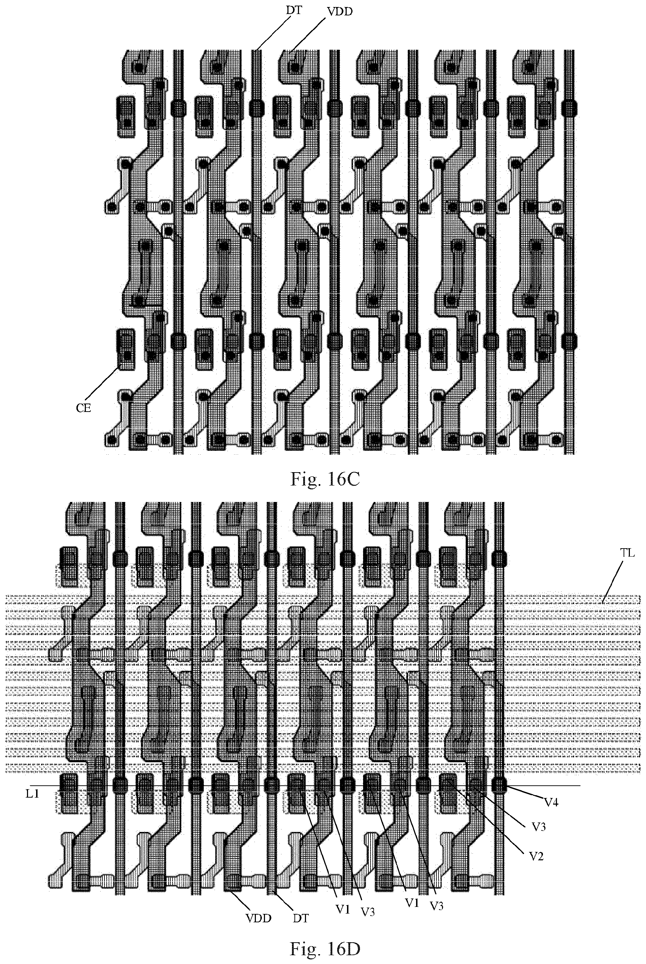

For example, in the embodiment of Fig. 6, the third conductive layer SD1 and the first planarization layer PLN1 of the display substrate are slightly different from the above embodiment. As shown in Fig. 16A, for the embodiment of Fig. 6, the pattern of the fourth connection electrode 14 in the third conductive layer SD1 has a long straight part; as shown in Fig. 16B, the plurality of first via holes V1, the plurality of second via holes V2, the plurality of power supply via holes V3 and the plurality of data via holes V4 in the first planarization layer PLN1 are provided in the same straight line, that is, in the first straight line L1. Fig. 16C shows a schematic plan view of the fourth conductive layer SD2 overlapping with the first conductive layer SD1, and Fig. 16D shows a schematic plan view of the first connection wire TL overlapping with the fourth conductive layer SD2 and the first conductive layer SD1. As shown in Fig. 16D, the extension direction of the first connection wire TL is parallel to the extension direction of the first straight line L1, which is the row direction of the plurality of first pixel driving circuits DR1 and the plurality of second pixel driving circuits DR2.

For example, in the embodiments of the present disclosure, the base substrate BS is a flexible base substrate or a rigid base substrate. The rigid base substrate includes but does not limit to one or more of glass and quartz; the flexible base substrate includes but does not limit to one or more of polyethylene terephthalate, polyethylene terephthalate, polyether ether ketone, polystyrene, polycarbonate, polyarylate, polyarylester, polyimide, polyvinyl chloride, polyethylene and textile fiber. For example, in some examples, the flexible base substrate comprises a first flexible material layer, a first inorganic material layer, a semiconductor layer, a second flexible material layer and a second inorganic material layer which are stacked. The materials of the first flexible material layer and the second flexible material layer for example are polyimide (PI), polyethylene terephthalate (PET), a surface-treated polymer soft film and the like; the materials of the first inorganic material layer and the second inorganic material layer for example are silicon nitride (SiNx), silicon oxide (SiOx) and the like to improve the water-oxygen resistance of the base substrate, and the material of the semiconductor layer for example is amorphous silicon (a-si).

For example, the first conductive layer Gate1, the second conductive layer Gate2, the third conductive layer SD1 and the fourth conductive layer SD2 are made of metal materials such as any one or more of titanium (Ti), copper (Cu), aluminum (Al) and molybdenum (Mo), or alloy materials of the above metals such as aluminum-neodymium alloy (AlNd) or molybdenum-niobium alloy (MoNb), and has a single-layer structure or a multi-layer structure such as Mo/Cu/Mo and the like. The first connection wire TL for example adopts a single-layer structure such as indium tin oxide ITO or indium zinc oxide IZO, or adopts a multi-layer composite structure such as ITO/Ag/ITO. The first gate insulating layer GI1, the second gate insulating layer GI2 and the interlayer insulating layer IDL for example adopt any one or more of silicon oxide (SiOx), silicon nitride (SiNx) and silicon oxynitride (SiON), and have a single-layer structure, a multi-layer structure or a composite-layer structure. The planarization layers such as the first planarization layer PLN1, the second planarization layer PLN2, the third planarization layer PLN3 and the like for example are made of organic materials, such as polyimide, resin and the like. The semiconductor material layer ACT for example is made of amorphous indium gallium zinc oxide (a-IGZO), zinc oxynitride (ZnON), indium zinc tin oxide (IZTO), amorphous silicon (a-Si), polysilicon (p-Si), hexathiophene, polythiophene and the like.

For example, the first electrode E1 of the first light-emitting element EL1 and the second light-emitting element EL2 is made of a transparent metal oxide such as indium tin oxide (ITO), indium zinc oxide (IZO), gallium zinc oxide (GZO) and the like, or a stack of the transparent metal oxide and a metal (such as silver). The material of the second electrode E2 for example adopts a metal material such as lithium (Li), aluminum (Al), magnesium (Mg), silver (Ag) and the like.

The embodiments of the present disclosure do not specifically limit the material of each functional layer of the display substrate.

At least one embodiment of the present disclosure further provides a display device, and the display device comprises the display substrate provided by the embodiments of the present disclosure. The display device for example is a mobile phone, a tablet computer, a television, a monitor, a notebook computer, a digital photo frame, a navigator and other products or components with display functions.

The following points need to be explained:

(1) The drawings of the embodiments of the disclosure only relate to the structure related to the embodiments of the disclosure, and other structures may refer to the general design.

(2) For the sake of clarity, in the drawings used to describe the embodiments of the present disclosure, the thickness of layers or regions is enlarged or reduced, that is, these drawings are not drawn to actual scale. It will be understood that when an element such as a layer, film, region or base substrate is referred to as being "on" or "under" another element, the element may be directly "on" or "under" another element or an intervening element may be present.

(3) In the case of no conflict, the embodiments of the present disclosure and the features in the embodiments of the disclosure can be combined with each other to obtain a new embodiment.

The foregoing embodiments merely are exemplary embodiments of the disclosure, and not intended to define the scope of the disclosure, and the scope of the disclosure is determined by the appended claims.

**Claims**

1.  A display substrate comprising:

    a base substrate, comprising a first display region and a second display region, wherein the first display region at least partially surrounds the second display region, and a light transmittance of the second display region is greater than a light transmittance of the first display region;
    a plurality of pixel driving circuits, provided on the base substrate and in the first display region;
    a first planarization layer, provided on a side of the plurality of pixel driving circuits facing away from the base substrate;
    a plurality of light-emitting elements, provided on a side of the first planarization layer facing away from the base substrate;
    a first power supply signal wire, provided on the side of the first planarization layer facing away from the base substrate and in the first display region; and
    a data signal wire, provided on the side of the first planarization layer facing away from the base substrate and in the first display region; wherein:

    the first planarization layer comprises an element connection via hole electrically connecting at least one of the plurality of pixel driving circuits with at least one of the plurality of light-emitting elements, a power supply via hole electrically connecting at least one of the plurality of pixel driving circuits with the first power supply signal wire, and a data via hole electrically connecting at least one of the plurality of pixel driving circuits with the data signal wire;
    the element connection via hole, the power supply via hole and the data via hole are arranged along a first direction.

2.  The display substrate according to claim 1, further comprising:

    a first initialization signal wire, configured to provide a first initialization signal to at least one of the plurality of pixel driving circuits;
    wherein a shortest distance between the element connection via hole and the first initialization signal wire, a shortest distance between the power supply via hole and the first initialization signal wire, and a shortest distance between the data via hole and the first initialization signal wire are substantially equal to each other.

3.  The display substrate according to claim 2, wherein

    the plurality of pixel driving circuits comprise a first pixel driving circuit and a second pixel driving circuit, and the plurality of light-emitting elements comprise a first light-emitting element provided in the first display region and a second light-emitting element provided in the second display region;
    the element connection via hole comprises a first via hole and a second via hole, the first light-emitting element is electrically connected with the first pixel driving circuit through the first via hole, the second light-emitting element is electrically connected with the second pixel driving circuit through a first connection wire provided in the first display region and the second display region, and in the first display region, the first connection wire is electrically connected with the second pixel driving circuit through the second via hole.

4.  The display substrate according to claim 3, wherein:

the plurality of pixel driving circuits comprise a plurality of pixel circuit groups extending in the first direction and arranged in a second direction, and at least one of the plurality of pixel circuit groups comprises a plurality of first pixel driving circuits and a plurality of second pixel driving circuits;

a plurality of first via holes, a plurality of second via holes, a plurality of power supply via holes and a plurality of data via holes adopted by the plurality of first pixel driving circuits and the plurality of second pixel driving circuits are arranged along the first direction, and the first direction and the second direction intersect with each other.

5. The display substrate according to claim 4, wherein the plurality of first via holes, the plurality of second via holes, the plurality of power supply via holes and the plurality of data via holes adopted by the plurality of first pixel driving circuits and the plurality of second pixel driving circuits in the at least one of the plurality of pixel circuit groups are provided to have shortest distances substantially equal to each other from the first initialization signal wire.

6. The display substrate according to claim 4 or 5, wherein the plurality of first via holes, the plurality of second via holes, the plurality of power supply via holes and the plurality of data via holes adopted by the plurality of first pixel driving circuits and the plurality of second pixel driving circuits in the at least one of the plurality of pixel circuit groups are provided in a same straight line, and the same straight line extends along the first direction.

7. The display substrate according to claim 6, wherein in a direction parallel to the base substrate, the first connection wire is provided on at least one side of the same straight line.

8. The display substrate according to claim 7, wherein an extension direction of the first connection wire from the first display region to the second display region is parallel to the first direction.

9. The display substrate according to any one of claims 2-8, wherein:

the first pixel driving circuit and the second pixel driving circuit respectively comprise a first transistor serving as a reset transistor, a second transistor serving as a compensation transistor and a third transistor serving as a driving transistor;

a gate electrode of the first transistor is connected with a reset signal wire, a first electrode of the first transistor is connected with the first initialization signal wire, a second electrode of the first transistor is respectively connected with a first electrode of the second transistor and a gate electrode of the third transistor; a gate electrode of the second transistor is connected with a scanning signal wire, and a second electrode of the second transistor is connected with a second electrode of the third transistor;

the gate electrode of the first transistor, the gate electrode of the second transistor, the gate electrode of the third transistor, the scanning signal wire and the reset signal wire are provided in a first conductive layer provided on the base substrate;

the first initialization signal wire is provided in a second conductive layer, and the second conductive layer is provided on a side of the first conductive layer facing away from the base substrate.

10. The display substrate according to claim 9, wherein:

the first pixel driving circuit and the second pixel driving circuit further respectively comprise a storage capacitor, a fourth transistor serving as a data writing transistor and a fifth transistor serving as a light emission control transistor;

a gate electrode of the fourth transistor is connected with the scanning signal wire, a first electrode of the fourth transistor is connected with the data signal wire, a second electrode of the fourth transistor is connected with a first electrode of the third transistor, a gate electrode of the fifth transistor is connected with a light emission control wire, a first electrode of the fifth transistor is connected with a second electrode plate of the storage capacitor, and a second electrode of the fifth transistor is connected with the first electrode of the third transistor;

the light emission control wire is provided in the first conductive layer.

11. The display substrate according to claim 10, wherein:

the first pixel driving circuit and the second pixel driving circuit further respectively comprise a sixth transistor serving as a light emission control transistor and a seventh transistor serving as a reset transistor;

a gate electrode of the sixth transistor is connected with the light emission control wire, a first electrode of the sixth transistor is connected with the second electrode of the third transistor, the first light-emitting element or the second light-emitting element is connected with a second electrode of the sixth transistor, a gate electrode of the seventh transistor is connected with the reset signal wire, a first electrode of the seventh transistor is connected with a second initialization signal wire, and a second electrode of the seventh transistor is connected with the second electrode of the sixth transistor;

the second initialization signal wire is provided in the second conductive layer.

12. The display substrate according to claim 11, wherein in the first direction parallel to the base substrate, the second initialization signal wire, the reset signal wire, the first initialization signal wire and the scanning signal wire for a same first pixel driving circuit or a same second pixel driving circuit are sequentially arranged.

13. The display substrate according to any one of claims 10-12, wherein:

the second transistor comprises an active layer and two gate electrodes, the active layer is provided in a semiconductor material layer provided between the first conductive layer and the base substrate;

the active layer comprises a first portion, and an orthographic projection of the first portion on the base substrate does not overlap with orthographic projections of the two gate electrodes on the base substrate;

the second conductive layer comprises a shielding pattern, and the orthographic projection of the first portion on the base substrate overlaps with an orthographic projection of the shielding pattern on the base substrate.

14. The display substrate according to claim 13, wherein the shielding pattern is integrally connected with the first initialization signal wire.

15. The display substrate according to claim 13 or 14, wherein:

the semiconductor material layer comprises a semiconductor pattern for connecting the active layer of the second transistor with an active layer of the first transistor;

an orthographic projection of the semiconductor pattern on the base substrate overlaps with the orthographic projection of the shielding pattern on the base substrate.

16. The display substrate according to any one of claims 9-15, wherein the first electrode and the second electrode of the first transistor, the first electrode and the second electrode of the second transistor, and the first electrode and the second electrode of the third transistor are provided in a third conductive layer, and the third conductive layer is provided on a side of the second conductive layer facing away from the base substrate.

17. The display substrate according to claim 16, wherein the first power supply signal wire is provided in a fourth conductive layer, and the fourth conductive layer is provided on a side of the third conductive layer facing away from the base substrate.

18. The display substrate according to claim 17, wherein the data signal wire is provided in the fourth conductive layer.

19. The display substrate according to any one of claims 16-18, wherein:

the third conductive layer further comprises a connection portion provided between the second electrode of the first transistor and the gate electrode of the third transistor;

the first power supply signal wire further comprises a protrusion;

an orthographic projection of the connection portion on the base substrate overlaps with an orthographic projection of the protrusion on the base substrate.

20. The display substrate according to claim 19, wherein the orthographic projection of the connection portion on the base substrate is within the orthographic projection of the protrusion on the base substrate.

21. The display substrate according to any one of claims 9-20, wherein an interval between patterns of the third conductive layer of the first pixel driving circuit and the second pixel driving circuit provided in two adjacent rows is from 7.0 microns to 10.0 microns.

22. The display substrate according to any one of claims 2-21, wherein among the plurality of first pixel driving circuits and the plurality of second pixel driving circuits of at least one pixel circuit groups, two first pixel driving circuits are provided between every two adjacent second pixel driving circuits.

23. A display device, comprising the display substrate according to any one of claims 1-22.

Fig. 1

Fig. 2

10

Fig. 3

Fig. 4

Fig. 5

Fig. 6

Fig. 7

Fig. 8

ACT

Fig. 9

**Gate1**

Fig. 10A

T7g  T1g

T2g  T4g

T3g

T6g

T5g

EM

Res

Gate

EM

Res

Fig. 10B

**Gate2**

Vin2

Vin1

SH/SH2

SH/SH1

C2

Vin2

Vin1

Fig. 11A

EM

Vin2
Res
Vin1
P2
SH/SH2
P1
SH/SH1
Gate

C1/C2

Fig. 11B

13
12
11
14
16
15
D1

Fig. 12A

Vin2

Vin1

Gate

C1/C2

EM

Vin2

Vin1

Fig. 12B

Fig. 13

DT   VDD

VDP

CE

Fig. 14A

DT   VDD

VDP

11

V1

CE

V3

V4

V3

V2

Fig. 14B

DT   VDD

EM

Vin2
Res
Vin1

C1/C2

Fig. 14C

DT   VDD

TL

V4

V3

V2

V1  V3   V1  V3

Fig. 15

SD1

Fig. 16A

Fig. 16B

DT  VDD

CE

Fig. 16C

TL

L1

VDD  DT  V1  V3  V1  V3

V4

V3

V2

Fig. 16D

## INTERNATIONAL SEARCH REPORT

| International application No. |
|---|
| **PCT/CN2022/096404** |

| A. | CLASSIFICATION OF SUBJECT MATTER |
|---|---|

H01L 27/32(2006.01)i;  H01L 51/52(2006.01)i

According to International Patent Classification (IPC) or to both national classification and IPC

| B. | FIELDS SEARCHED |
|---|---|

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS, CNTXT, CNKI: 全面屏, 屏下摄像, 全屏显示, 过孔, 接触孔, 连接孔, 直线, 方向, 平行, 电极, 电源线, 电源信号线, 数据线, 数据信号线; VEN, EPTXT, USTXT, IEEE: full display, full screen, under display camera, via ole, connect hole, touch hole, throuth hole, contact hole, beeline, orientation, parallel, electrode, power line, power signal line, data line, data siganl line

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 112271205 A (WUHAN CHINA STAR OPTOELECTRONICS SEMICONDUCTOR DISPLAY TECHNOLOGY CO., LTD.) 26 January 2021 (2021-01-26) description, paragraphs 33-83, and figures 3-12 | 1-23 |
| A | CN 113053981 A (BOE TECHNOLOGY GROUP CO., LTD. et al.) 29 June 2021 (2021-06-29) entire document | 1-23 |
| A | CN 112951892 A (HEFEI BOE ZHUOYIN TECHNOLOGY CO., LTD. et al.) 11 June 2021 (2021-06-11) entire document | 1-23 |
| A | CN 111477669 A (BOE TECHNOLOGY GROUP CO., LTD.) 31 July 2020 (2020-07-31) entire document | 1-23 |
| A | JP 2007148219 A (SEIKO EPSON CORP.) 14 June 2007 (2007-06-14) entire document | 1-23 |
| A | US 2011111540 A1 (SAMSUNG MOBILE DISPLAY CO., LTD.) 12 May 2011 (2011-05-12) entire document | 1-23 |

☐ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 August 2022** | **01 September 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

| International application No. |
|---|
| **PCT/CN2022/096404** |

| Patent document cited in search report | | | Publication date (day/month/year) | Patent family member(s) | | | Publication date (day/month/year) |
|---|---|---|---|---|---|---|---|
| CN | 112271205 | A | 26 January 2021 | None | | | |
| CN | 113053981 | A | 29 June 2021 | None | | | |
| CN | 112951892 | A | 11 June 2021 | None | | | |
| CN | 111477669 | A | 31 July 2020 | CN | 114175265 | A | 11 March 2022 |
| | | | | WO | 2021227760 | A1 | 18 November 2021 |
| | | | | WO | 2021227553 | A1 | 18 November 2021 |
| JP | 2007148219 | A | 14 June 2007 | None | | | |
| US | 2011111540 | A1 | 12 May 2011 | US | 2008121886 | A1 | 29 May 2008 |
| | | | | KR | 100752388 | B1 | 27 August 2007 |

Form PCT/ISA/210 (patent family annex) (January 2015)

**REFERENCES CITED IN THE DESCRIPTION**

**Patent documents cited in the description**

- CN 2021118279 W
- CN 2022082809 W